(19) Europäisches Patentamt
European Patent Office
Office européen des brevets

(11) Numéro de publication: **0 214 916 B1**

(12) # FASCICULE DE BREVET EUROPEEN

(45) Date de publication de fascicule du brevet: **30.09.92**

(51) Int. Cl.5: **H01L 23/52**, H01L 21/48

(21) Numéro de dépôt: **86420188.4**

(22) Date de dépôt: **11.07.86**

(54) **Procédé de fabrication d'un substrat d'interconnexion pour composants électroniques.**

(30) Priorité: **16.07.85 FR 8510871**

(43) Date de publication de la demande:
**18.03.87 Bulletin 87/12**

(45) Mention de la délivrance du brevet:
**30.09.92 Bulletin 92/40**

(84) Etats contractants désignés:
**AT BE CH DE GB IT LI LU NL SE**

(56) Documents cités:
**EP-A- 0 132 740**
**EP-A- 0 145 599**
**US-A- 4 413 061**

(73) Titulaire: **XERAM**
**Tour Manhattan 6, place de l'Iris La Défense**
**F-92400 Courbevoie(FR)**

(72) Inventeur: **Dubuisson, Jacques**
**22, avenue Emile Zola**
**F-75015 Paris(FR)**

(74) Mandataire: **Pascaud, Claude et al**
**PECHINEY 28, rue de Bonnel**
**F-69433 Lyon Cédex 3(FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

EP 0 214 916 B1

## Description

La présente invention concerne un procédé de fabrication d'un substrat d'interconnexion pour composants électroniques, ainsi que le substrat ainsi obtenu.

Un tel substrat est formé d'un empilement fritté de feuilles de matériau diélectrique dont certaines au moins portent des motifs conducteurs internes, ce substrat présentant des émergences conductrices pour assurer la liaison aux bornes du (des) composant(s), avec au moins une couche interne pourvue de pistes conductrices assurant l'interconnexion de couche à couche et avec ces émergences selon un schéma préétabli, au moyen de vias métallisés.

Une telle structure de substrat est par exemple décrite dans le EP-A-0 145 599, intitulé "Substrat d'interconnexion en alumine pour composant électronique, et procédé pour sa fabrication", déposé au nom de EUROFARAD-EFD.

L'un des buts de la présente invention est de réaliser un substrat d'interconnexion présentant une très faible constante diélectrique relative, permettant en particulier son utilisation pour des applications hyperfréquences; en effet, dans ces domaines, la propagation dépend directement de $1/\sqrt{K}$, K étant la constante diélectrique relative. Pour un fonctionnement satisfaisant, il est nécessaire que la valeur de K soit comprise entre 4 et 5,5.

Un autre but de l'invention est la réalisation d'un substrat qui, outre les excellentes propriétés diélectriques, présente un faible coefficient de dilatation, tout en conservant d'excellentes propriétés mécaniques.

A cet égard, il est souhaitable que l'ordre de grandeur de ce coefficient soit de 1 à $3.10^{-6}$, valeur adaptée au coefficient du silicium ($3.10^{-6}$) constituant les puces qui pourront être rapportées sur ce substrat.

A cet égard, il a été constaté que les céramiques de type cordiérite pouvaient permettre d'atteindre ces différents objectifs.

On connaît ainsi par le document EP 132 740 un procédé d'obtention de substrat diélectrique du type multicouche céramique, comportant essentiellement le mélange d'une poudre de cordiérite cristalline, naturelle ou synthétique (obtenue par calcination de mélanges de talc, chaux ou autres silicates d'aluminium) avec un liant et son solvant, une coulée de ce mélange sous forme de feuilles, un séchage pour obtenir des feuilles crues sur lesquelles peuvent être formés de circuits métalliques, un empilage des feuilles et un chauffage entre 1300 et 1450 °C en atmosphère réductrice humide pour éliminer le liant et fritter les particules de cordiérite cristalline.

Par composition "de type cordiérite", on entendra une composition comprise dans le domaine 60 à 50 % $SiO_2$, S à 20 % MgO et 20 à 40 % $Al_2O_3$ du diagramme ternaire $SiO_2$-MgO-$Al_2O_3$ (ici et dans la suite, sauf indication contraire, toutes les proportions indiquées seront des proportions pondérales).

Plus précisément, le procédé de l'invention comprend les étapes de :

a) préparation d'une barbotine par mélange d'une poudre céramique de type cordiérite avec un liant organique, en présence d'un solvant;

b) coulage des feuilles de céramique crue à partir de cette barbotine;

c) séchage des feuilles pour évaporation du solvant;

d) sérigraphie des motifs conducteurs internes au moyen d'une première encre de métallisation, formée d'un pigment métallique, d'un véhicule organique et d'un solvant;

e) séchage de l'encre;

f) perçage en cru des vias;

g) remplissage des vias par une seconde encre de métallisation formée d'un pigment métallique, d'une charge de céramique, d'un véhicule organique et d'un solvant;

h) empilement des différentes feuilles pourvues de leurs motifs sérigraphiés respectifs;

i) perçage éventuel de trous pour fixation des prises de connexion, avec éventuellement métallisation des parois au moyen de la même encre de métallisation que celle utilisée pour la métallisation des vias (avec toutefois une viscosité plus faible);

j) compression de l'empilement en un bloc homogène;

k) évacuation des matières organiques résiduelles;

l) frittage de la céramique.

Dans un premier mode de mise en oeuvre, la poudre céramique est une poudre frittable à basse température, le frittage étant effectué à une température maximale inférieure à 1000 ° C.

On verra que le frittage peut être réalisé indifféremment en atmosphère oxydante ou réductrice, les pigments métalliques des encres de métallisation devant alors être appropriés au caractère oxydant ou réducteur de l'atmosphère de frittage.

Dans un second mode de mise en oeuvre, la poudre céramique est une poudre frittable à haute température, le frittage étant effectué à une température maximale au moins égale à 1300 ° C.

Ici encore, le frittage pourra être réalisé soit en atmosphère réductrice, soit en atmosphère oxydante, les encres de métallisation étant choisies de manière appropriée.

D'autres caractéristiques et avantages apparaîtront à la lecture de la description détaillée ci-dessous des deux modes de mise en oeuvre précités.

A - FABRICATION D'UN SUBSTRAT D'INTERCONNEXION AVEC FRITTAGE A BASSE TEMPERATURE.

(par "basse température", on entendra une température maximale de frittage inférieure à 1050° C, généralement inférieure à 980 ° C).

1°/ Préparation de la poudre de cordiérite frittable à basse température

Un procédé permettant la préparation d'une telle poudre comprend par exemple les étapes consistant successivement :

- . à préparer une solution alcoolique mixte d'un sel d'aluminium et de silicium, lesdits sels devant être solubles dans l'alcool ou dans un solvant miscible avec l'alcool,
- . à préparer une solution d'un sel de magnésium soluble dans l'alcool ou dans un solvant miscible avec l'alcool ou encore dans son acide correspondant,
- . à préparer une solution en mélangeant les deux solutions précédentes sous agitation vigoureuse pour obtenir une solution homogène,
- . à ajouter à la solution précédente un agent hydrolysant sous forme de base faible totalement volatile, ce qui conduit à la formation d'un gel,
- . à traiter thermiquement le gel obtenu à une température au plus égale à 450° C pendant une durée au plus égale à 24 h,
- . à traiter thermiquement la poudre obtenue à une température comprise entre 450° C et 900° C pendant une durée au plus égale à 6 h.

De préférence, l'étape de traitement thermique de la poudre est précédée d'une étape de traitement par de l'eau oxygénée à une température comprise entre 60° C et 100° C, puis de filtrage de la suspension obtenue.

L'aluminium est introduit :

- soit sous forme d'un alcoxyde soluble dans l'alcool de formule :

$Al\,[O(CH_2)_n\,CH_3\,]_3$

dans laquelle n représente un nombre entier comprise entre 0 et 4.

On utilise avantageusement le butoxyde d'aluminium de formule :

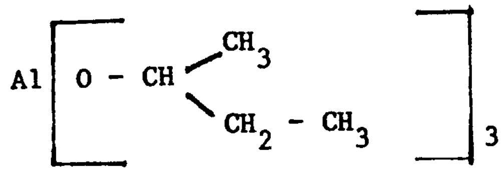

Mais d'autres alcoxydes conduisent également à de bons résultats, tels que l'éthoxyde, le propoxyde et l'isopropoxyde d'aluminium :

- soit sous forme de sels organiques ou complexes organiques, tels que l'acétate d'aluminium, le benzoate d'aluminium, l'acétylacétonate d'aluminium, le stéarate d'aluminium.

D'une façon générale, tous les sels ou complexes organiques solubles dans l'alcool ou solubles dans un solvant miscible avec l'alcool conviennent à la réalisation de l'invention :

- soit encore sous forme de sels minéraux, tels que le nitrate d'aluminium Al $(NO_3)_3$ hydraté ou non en solution alcoolique ou acétique, le chlorure d'aluminium Al $Cl_3$ en solution alcoolique; en portant cette dernière solution à l'ébullition pendant un temps suffisant, on élimine l'acide chlorhydrique et on génère l'alcoxyde d'aluminium correspondant.

D'une façon générale, tous les sels d'aluminium solubles dans l'alcool ou dans un solvant miscible avec l'alcool conviennent à la réalisation de l'invention.

Le silicium est introduit :

- soit sous forme d'un alcoxyde soluble dans l'alcool de formule :

$Si\,[O\,(CH_2)_n\,CH_3\,]_4$

dans laquelle n représente un nombre entier compris entre 0 et 4.

On utilise avantageusement l'éthoxyde de silicium de formule

$Si\,[OC_2H_5\,]_4$

Mais d'autres alcoxydes de silicium conduisent également à de bons résultats, tels que le propoxyde, l'isopropoxyde et le butoxyde de silicium :

- soit sous forme d'esters ou de sels tels que le tétracétate de silicium $(CH_3\text{-}COO)_4$ Si soluble dans l'acide acétique, ou encore un silicate d'ammonium quaternaire.

D'une façon générale, tous les esters ou sels solubles dans l'alcool ou solubles dans un solvant miscible avec l'alcool, ou encore dans leur acide correspondant conviennent à la réalisation de l'invention.

Le magnésium est introduit :

- soit sous forme d'un ester ou d'un sel.

On utilise avantageusement l'acétate de ma-

gnésium $Mg(CH_3COO)_2$ hydraté ou non dans de l'acide acétique anhydre.

D'autres esters peuvent être utilisés de la même façon, tels que benzoate, propionate, oléate, stéarate de magnésium.

D'une façon générale, tout ester ou sel de magnésium soluble dans l'alcool ou dans un solvant miscible avec l'alcool, ou encore dans son acide correspondant convient à la réalisation de l'invention :

- soit sous forme de sels minéraux, tels que nitrate ou chlorure de magnésium hydraté ou non en solution alcoolique.

La solution mixte de sels d'aluminium et de silicium est préparée en présence d'un alcool qui peut être par exemple l'isopropanol.

L'hydrolyse qui conduit à la formation du gel s'effectue à une température généralement comprise entre 20° C et 80° C, de préférence entre 20° C et 50° C par une base faible, telle que l'hydrazine hydratée $NH_2$ -$NH_2$, $H_2O$.

D'une façon générale, toute base faible ne contenant que des ions volatils, telle que l'ammoniaque dilué, l'hydroxylamine, les sels d'ammonium d'acide faible (carbonate d'ammonium, carbamate d'ammonium) convient à la réalisation de cette phase du procédé.

On utilise cependant de façon préférentielle l'hydrazine hydratée, car celle-ci joue le rôle d' égalisateur" de cinétique d'hydrolyse. Ce rôle exercé par l'hydrazine hydratée sur les cinétiques d'hydrolyse est d'un intérêt tout particulier lorsque l'on utilise comme produits de départ des alcoxydes d'aluminium et de silicium et l'acétate de magnésium, qui ont des cinétiques d'hydrolyse différentes : l'alcoxyde d'aluminium s'hydrolyse facilement, l'alcoxyde de silicium plus difficilement, l'acétate de magnésium se dissout dans l'eau. L'hydrazine hydratée permet de réaliser une hydrolyse partielle ou totale des alcoxydes accordant ainsi les vitesses de gélification et liant l'ion $Mg^{2+}$ au gel formé.

Il convient, à ce propos, de noter qu'il est souhaitable que la solution soit totalement exempte d'eau, car la moindre trace d'eau provoquerait une hydrolyse incontrôlée de l'alcoxyde le plus fragile, c'est-à-dire de l'alcoxyde d'aluminium. On note toutefois que si l'alcoxyde d'aluminium est remplacé par du nitrate d'aluminium, la présence de petites quantités d'eau n'est pas gênante.

Le traitement thermique auquel est soumis le gel après hydrolise s'effectue à une température au plus égale à 450° C, généralement comprise entre 200° C et 450° C, pendant une durée au plus égale à 24 h, généralement comprise entre 1 et 2 heures, la vitesse de montée en température étant par exemple comprise entre 50° C et 100° C/h. Le but de ce traitement thermique est d'éliminer la plus grande partie des solvants, de l'eau et de l'hydrazine. A l'issue de ce traitement, la poudre obtenue est de couleur légèrement jaunâtre.

La poudre est éventuellement lavée à l'eau oxygénée de préférence concentrée (20-30 %) à une température comprise entre 60° C et 100° C. Ce traitement à l'eau oxygénée a pour but d'éliminer les derniers radicaux organiques pouvant être liés aux métaux Al, Si ou Mg.

Le traitement à l'eau oxygénée peut être éventuellement remplacé par un barbottage d'air à une température comprise entre 80° C et 100° C.

On notera que cette étape de traitement à l'eau oxygénée peut être supprimée, si l'application à laquelle la poudre est destinée, n'est pas perturbée par la présence de traces de carbone, résultant de la pyrolyse de matières organiques non totalement éliminées par calcination lors du traitement thermique.

La poudre, après lavage à l'eau oxygénée, est soumise à un nouveau traitement thermique qui s'effectue à une température comprise entre 450°C et 900° C, généralement entre 550° C et 700° C pendant une durée au plus égale à 6 h, généralement comprise entre 30 et 120 min., afin d'éliminer l'eau de constitution et d'hydratation.

La poudre obtenue est une poudre relativement grossière qui, après un broyage léger, donne une poudre constituée de grains dont les dimensions sont comprises entre 0,01$\mu$ et 10 $\mu$, et est de couleur blanche.

2°/ <u>Préparation de la barbotine</u>

Une fois obtenue la poudre, on prépare une barbotine en mélangeant environ 1 partie de poudre et 1,5 partie d'un liant organique (parties en poids).

Le liant organique est de composition classique; il peut, par exemple, comprendre :

- alcool polyvinylique (environ 5 %)
- plastifiant (environ 15 %) tel que polyéthylèneglycol, éthylèneglycol, "cellosolve" (éther monoéthylique de l'éthylèneglycol),
- additifs appropriés : agent mouillant, défloculant, dispersant, antistatique,.....
- solvant aqueux.

En variante, on peut également utiliser la composition suivante :

- polyvinylbutyral,
- plastifiant tel que dibutylphtalate ou analogue,
- additifs,
- solvant organique tel que trichloréthylène, trichloréthane, méthyléthylcétone, ou alcool éthylique.

3°/ <u>Mise en forme de la céramique crue</u>

On réalise ensuite des feuilles de céramique crue par coulage de cette barbotine puis séchage des feuilles pour permettre l'évaporation du solvant, et découpe aux dimensions voulues.

4°/ Réalisation du composant

Une fois les feuilles de céramique crue préparées, on sérigraphie à leur surface les motifs internes respectifs au moyen d'une première encre de métallisation formée d'un pigment métallique, d'un véhicule organique (par exemple, l'éthylcellulose dans une proportion de 5 à 10 %) et d'un solvant (par exemple le terpinéol).

Dans le cas où le frittage sera réalisé sous atmosphère réductrice ou neutre ($H_2$, $H_2$ humide, $N_2$, Ar ou He), le pigment métallique de l'encre est choisi dans le groupe comprenant le cuivre et ses alliages à au moins 80 % de cuivre, le nickel et ses alliages, l'argent et ses alliage, le cuivre enrobé d'argent ou de nickel, ou même éventuellement l'or.

Après séchage de l'encre (par exemple séchage infrarouge), on superpose les différentes feuilles pour former l'empilement.

On procède ensuite au poinçonnage ou perçage en cru des vias destinés à assurer les interconnexions. Cette opération est réalisée de préférence par poincçonnage avec un système poinçon-matrice pour les feuilles d'épaisseur inférieur à 300 $\mu$m, et par perçage au moyen d'un foret entraîné à grande vitesse (plus de 30 000 tours par minute) et guidé par une machine de reconnaissance de forme pilotée par ordinateur, pour les feuilles de plus forte épaisseur.

Les vias sont ensuite métallisés; pour cela, on dépose une faible quantité d'une encre de métallisation, de composition particulière comprenant, en plus du pigment métallique chargé d'assurer la conductibilité, une faible quantité de céramique (moins de 5 % en pour assurer la création d'un "squelette" et permettre l'adhérence.

Le dépôt de l'encre peut se faire de différentes façons :

- soit en la forçant dans le via par un système poinçon-matrice (l'encre ayant été mise au préalable sous forme d'une feuille sèche indépendante, d'épaisseur régulière égale à l'épaisseur de la céramique);
- soit par "sérigraphie" (à l'écran de soie ou bien au pochoir), simple ou recto-verso, de la feuille;
- soit simplement par dépôt d'une goutte calibrée grâce à un dispositif distributeur piloté par ordinateur.

Généralement, on forme aussi des plots de sortie ou des collerettes aux débouchés des vias sur les faces du substrat par une opération supplémentaire de dépôt métallique.

A cet effet, dans une première variante, le métal du pigment corresdant est choisi dans le groupe comprenant l'argent, le palladium, les alliages argent-palladium, le cuivre et les alliages cuivre-nickel Ou cuivre-aluminium et l'or.

Ce dépôt est réalisé par sérigraphie avec une encre contenant le pigment métallique additionné d'une pâte de verre ou d'une pâte de céramique (de préférence une cordiérite) frittable à basse température, l'encre ainsi déposée étant cuite en atmosphère réductrice, soit au cours d'une étape de cuisson supplémentaire, soit par cofrittage en même temps que la céramique.

Le métal peut également être introduit dans le pigment sous forme d'oxyde réductible à la cuisson, par exemple sous forme d'oxyde de cuivre $Cu_2O$; dans ce dernier cas, l'oxyde de cuivre peut être le constituant majoritaire de la pâte de verre.

En variante, les plots de sortie ou les collerettes peuvent être déposés par évaporation sous vide ou pulvérisation cathodique après masquage, le métal correspondant étant choisi dans le groupe comprenant le nickel, les alliages cuivre-nickel et chrome-nickel, ainsi que l'or et le cuivre.

Dans l'un ou l'autre cas, le dépôt ainsi formé peut être rechargé par voie électrolytique ou chimique.

Le cas échéant, on peut également percer des trous pour fixer des conducteurs de sortie rapportés, ce qui évitera de pratiquer des brasures sur le substrat; le perçage sera effectué, à un diamètre approprié, au moyen d'un foret entraîné à grande vitesse, de la même manière que, pour un via.

Les parois de ces trous seront éventuellement métallisés (avant ou après cuisson du substrat), et dans ce cas, on emploiera la même encre de métallisation que celle ayant servi à la métallisation des vias, avec toutefois une plus faible viscosité.

Dans le cas où le frittage est réalisé en atmosphère oxydante, la succession des différentes étapes est identique.

En ce qui concerne le choix du pigment métallique :

- pour la réalisation des motifs conducteurs internes, celui-ci est choisi dans le groupe comprenant l'argent et ses alliages à au moins 75 % d'argent, et l'or;
- pour les vias, le pigment est le même, avec addition d'une charge de céramique;
- pour les plots de sortie, le pigment est le même, avec addition d'une pâte de verre ou de céramique; dans ce cas, il est possible de procéder à une seconde cuisson indifférement en atmosphère réductrice ou oxydante. En variante, il est possible de prévoir un dépôt par évaporation sous vide, de manière identique à celle exposée précédemment.

## Revendications

**1.** Procédé de fabrication d'un substrat d'interconnexion pour composants électroniques, du type formé d'un empilement fritté de feuilles de matériau diélectrique dont certaines au moins portent des motifs conducteurs internes, comprenant les étapes de :

a) préparation d'une barbotine par mélange d'une poudre céramique de composition de type cordiérite avec un liant organique, en présence d'un solvant;
b) coulage des feuilles de céramique crue à partir de cette barbotine;
c) séchage des feuilles pour évaporation du solvant;
d) sérigraphie des motifs conducteurs internes au moyen d'une première encre de métallisation;
e) séchage de l'encre;
f) perçage en cru de vias de connexion dans les feuilles
g) remplissage des vias par une seconde encre de métallisation;
h) empilement des différentes feuilles pourvues de leurs motifs sérigraphiés respectifs;
i) perçage éventuel de trous de fixation de prises de connexion, et éventuellement métallisation de ces trous;
j) compression de l'empilement en un bloc homogène;
k) évacuation des matières organiques résiduelles;
l) frittage de la céramique;

caractérisé en ce que la poudre céramique de l'étape (a) est préparée par (1) mélange d'une solution alcoolique d'un sel d'aluminium soluble dans l'alcool ou dans un solvant miscible à l'alcool et d'un sel de silicium soluble dans l'alcool ou dans un solvant miscible à l'alcool, avec une solution d'un sel de magnésium dans l'alcool ou dans un solvant miscible à l'alcool ou dans son acide correspondant, hydrolyse dudit mélange avec une base faible totalement volatile pour obtenir un gel, traitement thermique dudit gel à une température d'au plus 450° C pendant au plus 24 h, et traitement thermique de la poudre obtenue entre 450 et 900° C pendant au plus 6 h., et que le frittage de l'étape (1) est effectuée à au plus 1050° C.

**2.** Procédé de fabrication d'un substrat d'interconnexion pour composants électroniques selon la revendication 1, caractérisé en ce que le frittage est réalisé sous atmosphère réductrice ou neutre, les pigments métalliques des encres de métallisation étant choisis dans le groupe comprenant le cuivre et ses alliages à au moins 80 % de cuivre, le nickel et ses alliages, le cuivre enrobé d'argent ou de nickel, l'argent et ses alliages, et l'or.

**3.** Procédé de fabrication d'un substrat d'interconnexion pour composants électroniques, selon la revendication 1, caractérisé en ce que le frittage est réalisé sous atmosphère oxydante, les pigments métalliques des encres de métallisation étant choisis dans le groupe comprenant l'argent et ses alliages à au moins 75 % d'argent, et l'or.

**4.** Procédé de fabrication d'interconnexion pour composants électroniques, selon la revendication 1, caractérisé en ce qu'il est prévu une étape supplémentaire de finition par formation de collerettes au débouché des vias ou de plots de sortie, le métal correspondant étant choisi dans le groupe comprenant l'argent, le palladium, les alliages argent-palladium, le cuivre et les alliages cuivre-nickel ou cuivre-aluminium, et l'or, ce dépôt étant réalisé par sérigraphie avec une encre contenant le pigment métallique additionné d'une pâte de verre ou d'une pâte de céramique frittable à basse température, l'encre ainsi déposée étant cuite en atmosphère réductrice, le métal pouvant éventuellement être introduit sous forme d'oxyde réductible à la cuisson.

**5.** Procédé de fabrication d'un substrat d'interconnexion pour composants électroniques selon la revendication 1, caractérisé en ce qu'il est prévu une étape supplémentaire de finition par formation de collerettes au débouché des vias ou de plots de sortie, le métal correspondant étant choisi dans le groupe comprenant le nickel et les alliages cuivre-nickel et chrome-nickel, ainsi que l'or et le cuivre, le dépôt étant réalisé par évaporation sous vide ou pulvérisation cathodique après masquage.

## Claims

**1.** A method for the manufacture of an interconnection substrate for electronic components of the type formed from a sintered stack of sheets of dielectric material of which at least some sheets bear internal patterns of conductors, comprising the stages of:

a) preparing a slip by mixing a ceramic powder of cordierite type composition with an organic binder in the presence of a solvent,
b) casting unfired sheets of ceramic from this slip,
c) drying the sheets by evaporating the

solvent,

d) silk screen printing of internal conductor patterns using a first metallising ink,

e) drying of the ink,

f) drilling of connection paths through the sheets,

g) filling the paths with a second metallising ink,

h) stacking the various sheets together with their corresponding silk screen patterns,

i) drilling if necessary of any fixing holes or connections, and metallisation of such holes if necessary,

j) compressing of the stack into a homogeneous block,

k) removing residual organic matter,

l) sintering of the ceramic,

characterised in that the ceramic powder in stage (a) is prepared by (1) mixing an alcoholic solution of an aluminum salt which is soluble in alcohol or in a solvent which is miscible with alcohol and a silicon salt which is soluble in alcohol or in a solvent which is miscible with alcohol, with a solution of a magnesium salt in alcohol or in a solvent miscible with alcohol or in its corresponding acid, hydrolysis of the said mixture with a wholly volatile weak base to obtain a gel, heat treatment of the said gel at a temperature of at most 450 °C for at most 24 hours and heat treatment of the powder obtained between 450 and 900 °C for at most 6 hours, and in that the sintering in stage (1) is carried out at at most 1050 °C.

**2.** A method for the manufacture of an interconnection substrate for electronic components according to claim 1, characterised in that the sintering is performed under a reducing or neutral atmosphere, the metal pigments of the metallising inks being selected from the group comprising copper and its alloys containing at least 80% of copper, nickel and its alloys, copper clad with silver or nickel, silver and its alloys, and gold.

**3.** A method for the manufacture of an interconnection substrate for electronic components according to claim 1, characterised in that the sintering is carried out under an oxidising atmosphere, the metallic pigments of the metallising inks being selected from the group comprising silver and its alloys containing at least 75% silver, and gold.

**4.** A method for the manufacture of an interconnection for electronic components according to claim 1, characterised in that provision is made for an additional finishing stage through the formation of collars at the outlets of the output paths or pads, the corresponding metal being selected from the group comprising silver, palladium, silver-palladium alloys, copper and copper-nickel or copper-aluminium alloys and gold, this deposition being carried out by silk screen printing using an ink containing the metal pigment together with an added glass paste or ceramic paste which can be sintered at low temperature, the ink so deposited being baked in a reducing atmosphere, and with the possibility of the metal being introduced in the form of an oxide which is reduced on baking.

**5.** A method for the manufacture of an interconnection substrate for electronic components according to claim 1, characterised in that provision is made for an additional finishing stage through the formation of collars at the outlets of the output paths or pads, the corresponding metal being selected from the group comprising nickel and copper-nickel and chromium-nickel alloys, and gold and copper, deposition being achieved by evaporation under vacuum or cathodic spraying after masking.

**Patentansprüche**

**1.** Verfahren zur Herstellung eines Zwischenverbindungsträgers für elektronische Bauelemente des Typs, der aus einem gesinterten Stapel von Lagen aus dielektrischem Material gebildet wird, von denen wenigstens einige innere Leitungsmuster tragen, das die Schritte:

a) Herstellen einer Aufschlämmung durch Mischen eines keramischen Pulvers einer Zusammensetzung des Cordierittyps mit einem organischen Bindemittel in Gegenwart eines Lösungsmittels;

b) Gießen von Rohkeramiklagen aus dieser Aufschlämmung;

c) Trocknen der Lagen zur Verdampfung des Lösungsmittels;

d) Siebdruck der inneren Leitungsmuster mittels einer ersten Metallisierungstinte;

e) Trocknen der Tinte;

f) Rohbohren von Verbindungslöchern in den Lagen;

g) Füllen der Löcher mit einer zweiten Metallisierungstinte;

h) Stapeln der verschiedenen, mit ihren jeweiligen siebgedruckten Mustern versehenen Lagen;

i) eventuelles Bohren von Löchern zur Befestigung von Verbindungsanschlüssen und gegebenenfalls Metallisierung dieser Löcher;

j) Kompression des Stapels zu einem homogenen Block;

k) Evakuieren der restlichen organischen Stoffe; und

l) Sintern der Keramik

umfaßt,

dadurch **gekennzeichnet,**

daß das keramische Pulver des Schrittes (a) durch (I) Mischen einer alkoholischen Lösung eines im Alkohol oder in einem mit dem Alkohol mischbaren Lösungmittel löslichen Aluminiumsalzes und eines im Alkohol oder in einem mit dem Alkohol mischbaren Lösungsmittel lösbaren Siliziumsalzes mit einer Lösung eines Magnesiumsalzes im Alkohol oder in einem mit dem Alkohl mischbaren Lösungsmittel oder in seiner entsprechenden Säure, Hydrolyse dieser Mischung mit einer völlig flüchtigen schwachen Base zum Erhalten eines Gels, Wärmebehandlung dieses Gels bei einer Temperatur von höchstens 450 °C während höchstens 24 h und Wärmebehandlung des erhaltenen Pulvers zwischen 450 und 900 °C während höchstens 6 h hergestellt wird und daß das Sintern des Schrittes l) bei höchstens 1050 °C durchgeführt wird.

**2.** Verfahren zur Herstellung eines Zwischenverbindungsträgers für elektronische Bauelemente nach dem Anspruch 1, dadurch gekennzeichnet,
daß das Sintern in reduzierender oder neutraler Atmosphäre durchgeführt wird, wobei die metallischen Pigmente der Metallisierungstinten in der Gruppe gewählt werden, die das Kupfer und seine Legierungen mit wenigstens 80 % Kupfer, das Nickel und seine Legierungen, das mit Silber oder Nickel umhüllte Kupfer, das Silber und seine Legierungen und das Gold aufweist.

**3.** Verfahren zur Herstellung eines Zwischenverbindungsträgers für elektronische Bauelemente nach dem Anspruch 1, dadurch gekennzeichnet,
daß das Sintern in oxidierender Atmosphäre durchgeführt wird, wobei die metallischen Pigmente der Metallisierungstinten in der Gruppe gewählt werden, die das Silber und seine Legierungen mit wenigstens 75 % Silber und das Gold aufweist.

**4.** Verfahren zur Herstellung eines Zwischenverbindungsträgers für elektronische Bauelemente nach dem Anspruch 1, dadurch gekennzeichnet,
daß ein ergänzender Endbearbeitungsschritt durch Bildung von Bünden am Ausgang der Löcher oder Ausgangsbuchsen vorgesehen wird, wobei das entsprechende Metall in der Gruppe gewählt wird, die das Silber, das Palladium, die Silber-Palladium-Legierungen, das Kupfer und die Kupfer-Nickel- oder Kupfer-Aluminium-Legierungen und das Gold aufweist, die Abscheidung durch Siebdruck mit einer Tinte durchgeführt wird, die das metallische Pigment mit Zusatz einer Glaspaste oder einer Keramikpaste, die bei niedriger Temperatur sinterbar ist, durchgeführt wird, die so abgeschiedene Tinte in reduzierender Atmosphäre eingebrannt wird, wobei das Metall eventuell in Form von beim Einbrennen reduzierbarem Oxid eingeführt werden kann.

**5.** Verfahren zur Herstellung eines Zwischenverbindungsträgers für elektronische Bauelemente nach Anspruch 1, dadurch gekennzeichnet,
daß ein ergänzender Endbearbeitungsschritt durch Bildung von Bünden am Ausgang der Löcher oder Ausgangsbuchsen vorgesehen wird, wobei das entsprechende Metall in der Gruppe gewählt wird, die das Nickel und die Kupfer-Nickel- und Chrom-Nickel-Legierungen sowie das Gold und das Kupfer aufweist, und die Abscheidung durch Vakuumverdampfung oder Kathodenzerstäubung nach Maskierung durchgeführt wird.